# EUROPEAN PATENT SPECIFICATION

(11) **EP 3 819 227 B1**
(45) Date of publication and mention of the grant of the patent: **03.01.2024**
(21) Application number: 20206228.7
(22) Date of filing: 06.11.2020
(51) Int. Cl.: B65D 25/06, B65D 25/10, H05K 13/00

(54) **CONTAINER FOR REELS OF ELECTRONIC COMPONENTS**
BEHÄLTER FÜR HASPELN ELEKTRONISCHER BAUTEILE
CONTENEUR POUR BOBINES DE COMPOSANTS ÉLECTRONIQUES

(30) Priority: 07.11.2019 IT 201900020560
(43) Date of publication of application: 12.05.2021
(73) Proprietor: I-Tronik S.r.l., 35010 Peraga di Vigonza (PD) (IT)
(72) Inventor: RIZZOLI, Lorenzo, 35010 Peraga di Vigonza (PD) (IT)
(74) Representative: Susanetto, Carlo

(56) References cited:
- US-A- 5 833 062
- US-A1- 2009 000 975
- US-A1- 2019 084 761

## Description

### Technical field

The present invention relates to a container, which is tray-shaped and provided with separators, and which is designed for the storage of reels on which tapes containing electronic components are wound which are used for assembling printed circuit boards, often referred to with the acronym PCB.

### Description of the prior art

In printed circuit board assembly operations, carried out according to the Surface-mount Technology, known in the art as SMT, the electronic components, indicated with SMD (Surface-mount Devices), are picked from the tapes directly by dedicated Pick and Place devices. In turn, the reels are moved between these devices and suitable storage devices by means of tray-shaped containers provided with suitable dividing walls to separate the reels from one another and keep them in a vertical position. The reels, usually containing a single type of SMD component each, may have different diameters and thicknesses which mainly depend on the type of components present in the reel itself; in particular, some standard diameters defined in inches are defined.

Therefore, it is required that the containers are able to accommodate reels of different formats, but the containers, in turn, are also intended to be handled by means of automatic handling and transport systems, so they have standard external dimensions, for example 40 cm x 60 cm, and are used for any type and dimension of reel.

In recent times, in addition to the more traditional reel formats, having a diameter of 10" or 7", reels with a larger diameter, of 15", are increasingly used.

However, the applicant has noted that the standard containers having dimensions of 40 cm x 60 cm are not suitable for accommodating these new reels with a larger diameter of 15".

In fact, the diameter of these reels is greater than the dimension of the internal width of the container, so it is often necessary to resort to some expedient to position them inside it, thereby sacrificing a part of the containment capacity (for example by orienting the reels in a position which is not vertical or not perpendicular to the lateral walls), or giving up the stability for holding the reels in the container (for example using containers with very low lateral walls).

The applicant has also noted that these standard containers are not very suitable for operating in combination with storage devices of the automatic type, for example like the one described in WO 2018189699 in the name of the same applicant, for example, where the reels are dropped into the container.

Finally, the applicant has noted that these standard containers do not allow comfortable, in particular manual, gripping of the reels with a smaller diameter, of 7", due to the presence of the dividing walls.

At the same time, the applicant has noted that the modification of the external dimensions of the standard containers would entail a significant increase in costs, due both to the production of the new containers, and to their management and, even more, to the adaptation of the storage and production machines operating with such containers.

Among the known containers, those without dividing walls may be recognized, in which, however, seats for reels are defined by means of suitable grooves. An example of these containers is described in U.S. Patent Application no. US 2017/0027091.

These containers may also include movable dividing walls, which however do not make the container itself flexible as regards the diametrical dimensions of the reels.

Other examples of known containers are described in Chinese patent no. CN 104206049.

A container according to the preamble of claim 1 is disclosed in US 2019/084761.

### Description of the invention

The technical problem addressed by the present invention is that of providing a container for reels of electronic components, in particular of the SMD type, which allows one or more of the drawbacks mentioned with reference to the prior art to be at least partially overcome.

Such a problem is solved by a container as specified above, which comprises a tray and a plurality of separators as defined in the appended main claim, while further preferred and additional features of the invention are defined in the appended dependent claims.

In particular, in a first aspect thereof, the present invention relates to a container comprising a tray and a plurality of separators.

The tray has a base and opposing lateral walls on which a top edge is defined.

Each separator is intended to be positioned in the tray so as to extend between the lateral walls thereof.

Each separator comprises a dividing wall which is constructed so as to extend away from the base of the tray and separates at least two reels from one another.

Each separator comprises a pair of bearing surfaces which bear on the respective top edges of the lateral walls.

The bearing surfaces are defined on opposing lateral edges of the separator.

Each separator comprises at least one support element projecting from the dividing wall so as to support at least one reel.

The support element defines a surface for supporting the reel, and said support surface intersects the lateral edges of the separator at a point positioned on the side opposite the top edge with respect to the bearing surface.

In this way, the separator supports the reel by means of the support element and, if the reel has a diameter greater than the internal dimensions of the tray (as in the case of a 15" reel in a 40 cm wide tray), said reel is supported in such a way that its widest section remains above the top edge of the lateral walls of the tray, where the separator rests. In this way, a certain measure of width is gained which allows reels larger than the internal dimensions of the tray to be positioned vertically and perpendicularly to the lateral walls, and, moreover, also in trays with relatively high lateral walls.

On account of these features, the container of the invention also allows reels with a diameter greater than the internal width of the tray to be stored in a stable and effective manner, for example it allows trays of standard dimensions 40 cm x 60 cm to also be used for containing reels with a 15" diameter.

In the aforementioned aspect, the present invention may exhibit one or more of the preferred features described below.

In one embodiment, the support element comprises a slope which extends continuously from at least one of the lateral edges towards the base of the tray.

In this way, the support surface is continuous and may guide and accompany the reel in its insertion movement towards a central positioning seat of the support element, in the rest position. This advantageously allows the dropping movement of the reel inside the container to be attenuated, making it also suitable for receiving the reels dropping from an automatic storage device.

In other embodiments, the support element may have different shapes, for example it may be step-shaped, or it may be formed by inclined planes offset from one another, or by pins suitably arranged on the dividing wall.

In these cases, the support surface remains defined by the points of contact of the support element with the reel, and the point of intersection with the lateral edge is defined by the extension of the support surface thus defined.

In particular, it should be noted that the support element may not directly intersect the lateral edges of the separator.

Preferably, the slope is curved, with the concavity facing upwards away from the side opposite the base of the tray.

Preferably, the slope has a curvature substantially equal to the curvature of a reel of the maximum diameter intended to be received in the container.

Preferably, the dividing wall is constructed perpendicular to the base of the tray.

Preferably, the lateral edges of the separator, in the portion above the top edge of the lateral walls, are externally aligned with the lateral walls of the tray.

Preferably, the top edge of the lateral walls is flat, more preferably is a plane parallel to the base of the tray.

In one embodiment, the separator comprises a first and a second support element, each extending from a respective lateral edge of the separator towards the base of the tray, so as to form a cavity for positioning the reel centrally with respect to the lateral edges.

Preferably, the first and second support elements are specular with respect to a median axis of the separator.

Preferably, the first and second support elements are spaced apart on a lower edge of the separator.

In this way, a free space remains between the two support elements which defines a seat for positioning the reel in the separator, which promotes the retention of the reel in the rest position.

Preferably, the bearing surfaces are defined on a step of the lateral edge of the separator.

In one embodiment, the support element comprises a lip which projects from the dividing wall and defines a bearing profile of the separator on the internal surface of the lateral wall of the tray and on the base thereof. Preferably, the lip is connected to the slope and to the bearing surface so as to form a rib projecting from the dividing wall.

Preferably, such a rib extends continuously along the perimeter of the support element.

In one embodiment, the separators are fixed to the tray in a nonremovable manner.

In another embodiment, the separators are instead fixed to the tray in a removable manner.

In this way, the separators are made movable and may be positioned in the tray in an appropriate manner according to the type of reels to be contained.

In one embodiment, the separators are positioned in the tray so as to have the respective support elements always oriented on the same side. In this case, the space for inserting a reel between a pair of separators is substantially equal to the extent to which the support element projects from the dividing wall.

In another embodiment, the separators are positioned in the tray so as to have the respective support elements facing one another in twos.

In this way, the space for inserting a reel between a pair of separators is substantially equal to twice the extent to which the support element projects from the dividing wall.

In one embodiment, a recess is made on an upper edge of the dividing wall. More preferably, such a recess is made in a middle zone of the dividing wall and, even more preferably, such a recess has a semicircular shape.

In this way, gripping even a small diameter reel, such as a 7" reel in a standard 40 cm wide container, contained between the separators, is facilitated.

### Brief description of the drawings

The present invention will be described hereinafter according to a preferred embodiment thereof, provided by way of non-limiting example with reference to the accompanying drawings, in which:
* Figure 1 shows a perspective view of a container for reels of electronic components according to the present invention;
* Figure 2 shows a lateral and top perspective view of the container of Figure 1;
* Figures 3, 4 and 5 schematically show cross sections of the container of Figure 1, which illustrate the positioning of small, medium and large reels, respectively;

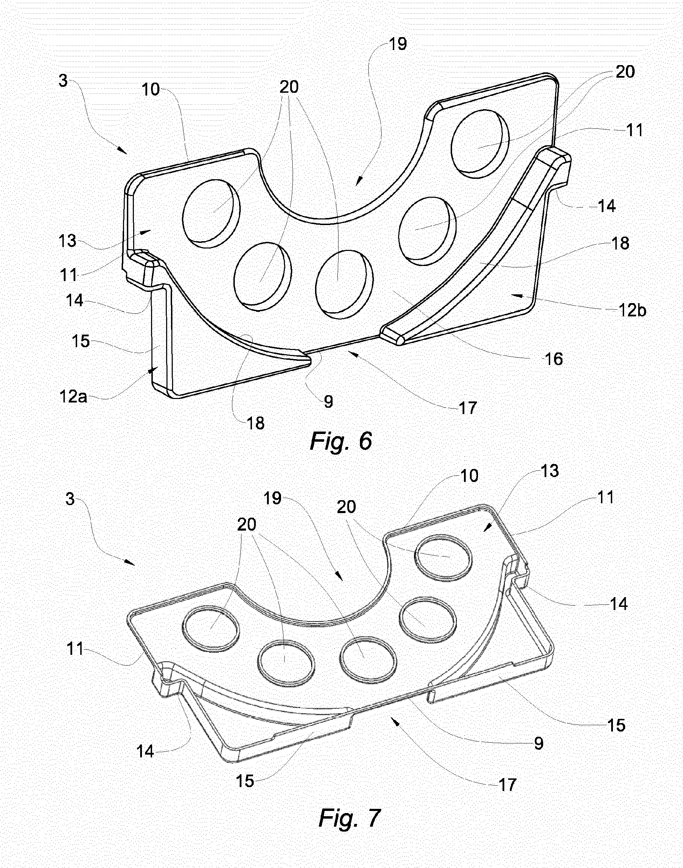

* Figure 6 shows a perspective view from one side of a separator used in the container of Figure 1;
* Figure 7 shows a perspective view from the opposite side of the separator of Figure 6; and

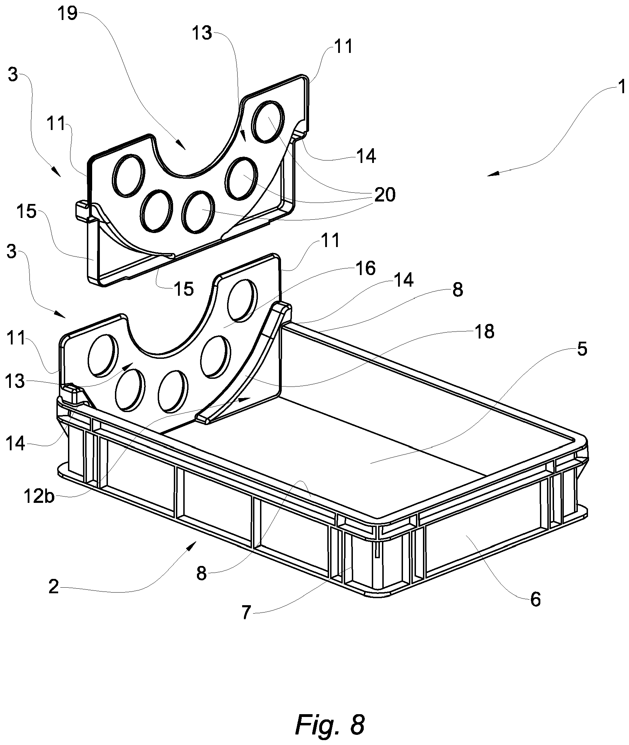

* Figure 8 shows a perspective view of the container of Figure 1, where the positioning of the separators is illustrated.

### Description of an embodiment of the invention

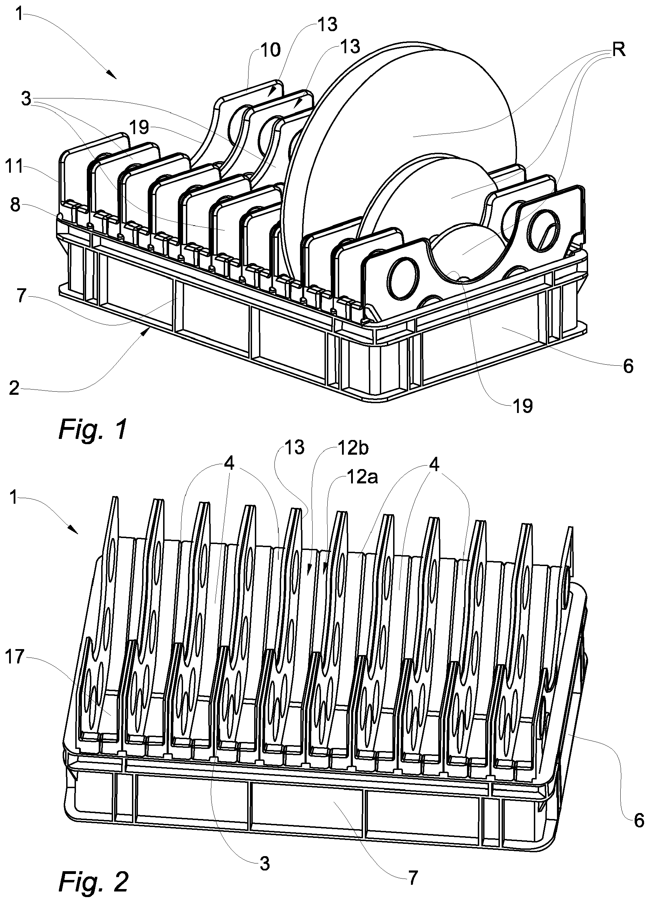

With reference to the figures, a container for reels of electronic components is indicated as a whole with reference numeral 1; it substantially consists of a tray 2 and a plurality of separators 3, inserted in the tray 2 as will be described in greater detail below, which define a plurality of insertion spaces 4 comprised between adjacent separators 3, where reels R of different dimensions may be positioned vertically, with respect to the base of the tray 2, as illustrated in Figures 1, 3, 4 and 5. The tray 2 has a substantially rectangular shape, comprising a flat base 5, as well as end walls 6 and lateral walls 7 formed respectively on the short sides and on the long sides of the tray 2.

The transverse and longitudinal sizes of the tray 2 are usually defined by specific standards, which allow them to be received and moved in automatic storage devices which use tray handling systems and recognition systems for the reels R, identified by codes imprinted thereon.

In the specific example described herein, the tray 2 measures, externally, 40 cm in width and 60 cm in length.

Each reel R contains a wound tape which sequentially accommodates a plurality of electronic components, intended for the assembly of printed circuits by means of so-called surface-mount technology.

In the present embodiment, the tray 2 has walls 6, 7 which extend orthogonally from the base 5, but it is understood that the present invention may also relate to trays with inclined lateral walls, so as to determine a flared tray cavity.

The base 5 and the lateral walls 7 of the tray 2 are smooth, do not have roughness such as ribs and grooves, and therefore represent a flat bearing base for the separators 3.

The walls 6, 7 of the tray 2, and in particular the lateral walls 7 thereof, have a top edge 8, which runs along all the walls 6 and 7 to define a bearing plane for the separators 3.

In this embodiment, the top edge is substantially flat, parallel to the base 5 of the tray 2, with a width of between 1 cm and 3 cm.

The separators 3 may be positioned on the tray in a fixed or removable manner and may be made in one piece, for example with a simple injection and moulding process.

Each separator 3 has a generally square and laminar shape, with a width substantially equal to the width of the tray 2, so as to extend between the two opposing lateral walls 7, oriented orthogonally to said lateral walls (as well as to the base 5) and parallel to the end walls 6.

Each separator 3 comprises a lower edge 9, an upper edge 10 and opposing lateral edges 11 and is divided longitudinally into a lower portion, which is inserted into the tray 2, and an upper portion, which remains projecting from the top edge 8 thereof.

In particular, each separator 3 comprises a dividing wall 13, which is formed by a sheet extending between the lower edge 9 and the upper edge 10 and separates the reels R from one another, as well as a first and a second support element 12a and 12b which project from a front side 16 of the dividing wall 13 and are intended to support a reel R inserted in the space 4.

Each separator 3 also comprises, on each of its lateral edges 11, a bearing surface 14 which cooperates with the bearing plane formed by the top edge 8 of the lateral walls 7 of the tray 2.

Since the bearing plane formed by the top edge 8 is oriented horizontally and parallel to the base 5 of the tray 2, the bearing surface 14 is also flat, horizontal and parallel to the base 5.

The bearing surface 14 is therefore facing towards the base 5, when the separator 3 is positioned vertically in the tray 2, and forms, on each lateral edge 11 of the separator 3, a step between an upper portion of the lateral edge 11 projecting from the tray 2 and a lower portion of the lateral edge 11 inside the cavity defined by the tray 2. Preferably, the upper portion of the lateral edge 11 is extended as an extension of the lateral walls 7, so as to be aligned externally with them, while the lower portion of the lateral edge 11 rests on the internal surface of the lateral wall 7.

The first and second support elements 12a and 12b are mainly formed on the lower portion of the separator 3 and are positioned in a substantially specular manner with respect to a median plane of the separator perpendicular to the dividing wall 13.

Each support element 12a and 12b comprises a slope 18 defining a surface for bearing the reel R when received in the insertion space 4.

The slope 18 extends continuously from an intermediate point of a relevant lateral edge 11 to the lower edge 9, so as to form a positioning cavity which is centred with respect to the lateral edges 11, in which cavity the reel R is received.

In particular, the point where the slope 18 intersects the relevant lateral edge 11 is positioned on the side opposite to the top edge 8 with respect to the bearing surface 14; in other words, the slope 18 starts above the top edge 8.

The slope 18 projects from the front side 16 of the dividing wall 13 by about 1 - 2 cm and has a curved profile with the concavity facing upwards, on the side opposite to the base 5 of the tray 2.

Preferably, the slope 18 has a curvature substantially equal to the curvature of a reel of the maximum diameter intended to be received in the container, in this case a 15" reel.

The respective slopes 18 of the first and second support elements 12a, 12b converge on the lower edge 9 in a position spaced from one another, in such a way that an intermediate free space is defined between them which substantially defines a positioning recess 17 for the reel inside the positioning cavity defined by the two slopes 18.

Each support element 12a, 12b further comprises a lip 15, which projects from the dividing wall 13 of the same size as the slope 18 and is connected to the ends thereof and to the bearing surface 14 so as to form a rib projecting from the dividing wall 13 and extending continuously along the entire perimeter of the support element.

The lip 15 thus defines a bearing profile of the separator 3 on the internal surface of the relevant lateral wall 7 and of the base 5 of the tray 2, making the positioning of the separator 3 particularly stable as it rests in the tray 2 on three sides (the two lateral walls 7 and the base 5), and on three different planes (the one defined by the top edge 8, the one defined by the lateral walls 7, and the one defined by the base 5).

The rear side of the dividing wall 13, opposite the front side, is substantially smooth. The symmetry of the separator 3 with respect to an intermediate perpendicular plane allows the use of a pair of separators 3 to form an insertion space 4 of variable width.

In fact, as may be seen for example in Figure 2, the separators 3 may be arranged in pairs in which, in each pair, the separators have the front sides 16 facing one another, thus forming an insertion space 4 in which the distance between the dividing walls 13 of the two separators is equal to twice the extent to which the support elements 12a and 12b project from the relevant dividing wall 13. In this way, the reel positioning cavity is delimited by the facing slopes 18 and has a central recess determined by the juxtaposition of the two positioning recesses 17.

The slopes 18, although juxtaposed, may also be slightly spaced to increase the space available between the dividing walls 13. In any case, the circular edges of the reel R inserted in the space 4 will rest on a relevant slope 18 of the two separators 3.

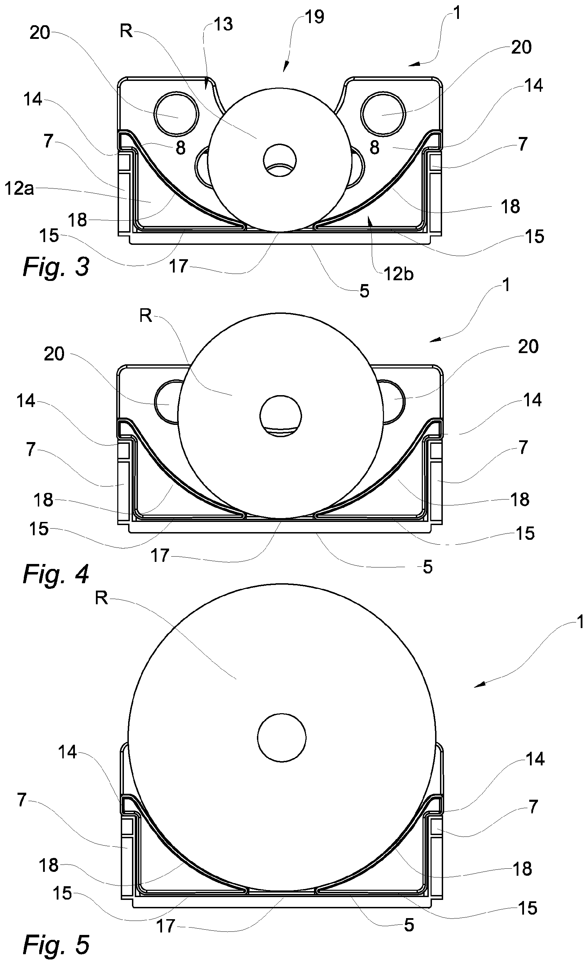

It should also be noted that the recess resulting from the juxtaposition of the two positioning recesses 17 allows a reel R of any size to always be positioned in the centre of the insertion space, as shown in Figures 3, 4 and 5.

In an alternative embodiment, not shown in the accompanying figures, the separators may be positioned in the tray 2 so as to have the respective support elements 12a, 12b always oriented on the same side. In this case, the insertion space 4 will have a width equal to the extent to which the support element 12a, 12b projects from the dividing wall 13. On the upper edge 10, in the middle zone thereof, the dividing wall 13 further comprises a recess 19, which in the present example has a semicircular shape. The recess 19 has the purpose of leaving a portion of reel R of smaller extension, for example 7", uncovered as it would otherwise be completely hidden between the dividing walls 13 of a pair of separators 3.

This particularity is particularly useful when picking up the reel from the container, whether this is done manually or by means of special manipulators.

Furthermore, the upper portion of the dividing wall 13 between the upper edge 10, the recess 19 and the support elements 12a and 12b has a plurality of holes 20, substantially for lightening, that are preferably equidistant from each other, arranged according to an intermediate circular profile between the one defined by the central opening 19 and the one defined by the two slopes 18.

A person skilled in the art may make several changes and variations to the container for reels of electronic components described above in order to meet further incidental needs, all falling within the scope of protection of the present invention as defined in the appended claims.

## Claims

1. Container (1) for reels (R) of electronic components, the container comprising a tray (2) which has a base (5) and opposing lateral walls (7) on which a top edge (8) is defined, and comprising a plurality of separators (3) which are positioned so as to extend between said lateral walls (7), wherein each separator (3) comprises:
- a dividing wall (13) which is constructed so as to extend away from said base (5) and which is intended to separate at least two reels from one another;
and **characterised in that** each separator (3) comprises:
- a pair of bearing surfaces (14) which are defined on opposing lateral edges (11) of said separator (3) and bear on the respective top edges (8) of said lateral walls (7);
- at least one support element (12a, 12b) which projects from said dividing wall (13) so as to support at least one reel and which defines a surface for supporting said reel (R) that intersects said lateral edges (11) at a point positioned on the side opposite to said top edge (8) with respect to said bearing surface (14).

2. Container (1) according to claim 1, wherein said at least one support element comprises a slope (18) which extends continuously from at least one of said lateral edges (11) towards the base (5) of the tray.

3. Container (1) according to claim 2, wherein said slope (18) has a curved profile having the concavity facing away from the side opposite the base of the tray.

4. Container (1) according to claim 3, wherein said slope (18) has a curvature which is substantially equal to the curvature of a reel having the maximum diameter intended to be received in the container.

5. Container (1) according to any one of the preceding claims, wherein a first and a second support element are provided, each extending from a respective lateral edge of said separator towards the base of said tray, so as to form a cavity for positioning said reel centrally with respect to said lateral edges (11).

6. Container (1) according to claim 5, wherein said first and second support element are spaced apart from one another on a lower edge (10) of said separator (3) so as to define a seat for positioning said reel in said separator.

7. Container (1) according to any one of the preceding claims, wherein said at least one support element comprises a lip (15) which projects from said dividing wall (13) and defines a bearing profile of said separator on the internal surface of said lateral wall (7) of the tray (2) and on said base (5).

8. Container (1) according to claim 7, wherein said lip (15) is connected to said slope (18) and to said bearing surface (14) in order to form a rib projecting from said dividing wall (13), which rib extends continuously along the perimeter of said support element.

9. Container (1) according to any one of the preceding claims, wherein said separators are positioned in said tray so as to have the respective support elements facing one another in twos.

10. Container (1) according to any one of the preceding claims, wherein a recess (19) is made in a middle zone of an upper edge (10) of said dividing wall (13), which recess facilitates gripping a reel contained between said separators (3).

## Patentansprüche

1. Behälter (1) für Rollen (R) von elektronischen Bauteilen, wobei der Behälter ein Tablett (2) aufweist, das eine Basis (5) und gegenüberliegende Seitenwände (7) aufweist, auf denen eine obere Kante (8) ausgebildet ist, und eine Mehrzahl von Trennvorrichtungen (3) aufweist, die positioniert sind, um sich zwischen den Seitenwänden (7) zu erstrecken, wobei jede Trennvorrichtung (3) aufweist:
- eine Trennwand (13), die konstruiert ist, um sich von der Basis (5) weg zu erstrecken, und die bestimmt ist, um zumindest zwei Rollen voneinander zu trennen;
und **dadurch gekennzeichnet, dass** jede Trennvorrichtung (3) aufweist:
- ein Paar von Auflageflächen (14), die an gegenüberliegenden Seitenkanten (11) der Trennvorrichtung (3) ausgebildet sind und auf den jeweiligen Oberkanten (8) der Seitenwände (7) aufliegen;
- zumindest ein Abstützelement (12a, 12b), das von der Trennwand (13) hervorsteht, um zumindest eine Rolle abzustützen, und das eine Fläche zum Abstützen der Rolle (R) bildet, die die Seitenkanten (11) in einem Punkt schneidet, der auf der der oberen Kante (8) gegenüberliegenden Seite in Bezug auf die Auflagefläche (14) positioniert ist.

2. Behälter (1) nach Anspruch 1, wobei das zumindest eine Abstützelement eine Schräge (18) aufweist, die sich kontinuierlich von zumindest einer der Seitenkanten (11) in Richtung der Basis (5) des Tabletts erstreckt.

3. Behälter (1) nach Anspruch 2, wobei die Schräge (18) ein gekrümmtes Profil mit einer Konkavität aufweist, die von der der Basis des Tabletts gegenüberliegenden Seite abgewandt ist.

4. Behälter (1) nach Anspruch 3, wobei die Schräge (18) eine Krümmung aufweist, die im Wesentlichen gleich der Krümmung einer Rolle mit dem maximalen Durchmesser ist, die im Behälter aufgenommen werden soll.

5. Behälter (1) nach einem der vorhergehenden Ansprüche, wobei ein erstes und ein zweites Abstützelement vorgesehen sind, die sich jeweils von einer entsprechenden Seitenkante der Trennvorrichtung in Richtung der Basis des Tabletts erstrecken, um einen Hohlraum zum Positionieren der Rolle in der Mitte der Seitenkanten (11) zu bilden.

6. Behälter (1) nach Anspruch 5, wobei das erste und zweite Abstützelement an einer unteren Kante (10) der Trennvorrichtung (3) voneinander beabstandet sind, um einen Sitz zum Positionieren der Rolle in der Trennvorrichtung zu bilden.

7. Behälter (1) nach einem der vorhergehenden Ansprüche, wobei das zumindest eine Abstützelement eine Lippe (15) aufweist, die von der Trennwand (13) hervorsteht und ein Auflageprofil der Trennvorrichtung auf der Innenfläche der Seitenwand (7) des Tabletts (2) und der Basis (5) bildet.

8. Behälter (1) nach Anspruch 7, wobei die Lippe (15) mit der Schräge (18) und der Auflagefläche (14) verbunden ist, um eine von der Trennwand (13) abstehende Rippe zu bilden, die sich kontinuierlich entlang des Umfangs des Abstützelements erstreckt.

9. Behälter (1) nach einem der vorhergehenden Ansprüche, wobei die Trennvorrichtungen im Tablett positioniert sind, sodass die jeweiligen Abstützelemente einander paarweise gegenüberliegen.

10. Behälter (1) nach einem der vorhergehenden Ansprüche, wobei eine Ausnehmung (19) in einem mittleren Bereich einer oberen Kante (10) der Trennwand (13) ausgebildet ist, die das Greifen einer zwischen den Trennwänden (3) enthaltenen Rolle ermöglicht.

## Revendications

1. Conteneur (1) pour bobines (R) de composants électroniques, le conteneur comprenant un plateau (2) qui a une base (5) et des parois latérales opposées (7) sur lesquelles un bord supérieur (8) est défini, et comprenant une pluralité de séparateurs (3) qui sont positionnés de manière à s'étendre entre lesdites parois latérales (7), dans lequel chaque séparateur (3) comprend :
- une paroi de division (13) qui est construite de manière à s'étendre à l'opposé de ladite base (5) et qui est destinée à séparer au moins deux bobines l'une de l'autre ;
et **caractérisé en ce que** chaque séparateur (3) comprend :
- une paire de surfaces d'appui (14) qui sont définies sur des bords latéraux opposés (11) dudit séparateur (3) et s'appuient sur les bords supérieurs respectifs (8) desdites parois latérales (7) ;
- au moins un élément de support (12a, 12b) qui fait saillie depuis ladite paroi de division (13) de manière à supporter au moins une bobine et qui définit une surface pour supporter ladite bobine (R) qui entrecoupe lesdits bords latéraux (11) en un point positionné sur le côté opposé audit bord supérieur (8) par rapport à ladite surface d'appui (14).

2. Conteneur (1) selon la revendication 1, dans lequel ledit au moins un élément de support comprend une pente (18) qui s'étend de façon continue depuis au moins un desdits bords latéraux (11) vers la base (5) du plateau.

3. Conteneur (1) selon la revendication 2, dans lequel ladite pente (18) présente un profil incurvé dont la concavité est orientée à l'opposé du côté opposé à la base du plateau.

4. Conteneur (1) selon la revendication 3, dans lequel ladite pente (18) présente une courbure qui est sensiblement égale à la courbure d'une bobine ayant le diamètre maximum destinée à être reçue dans le conteneur.

5. Conteneur (1) selon l'une quelconque des revendications précédentes, dans lequel un premier et un deuxième élément de support sont prévus, chacun s'étendant depuis un bord latéral respectif dudit séparateur vers la base dudit plateau, de manière à former une cavité pour positionner ladite bobine de manière centrale par rapport auxdits bords latéraux (11).

6. Conteneur (1) selon la revendication 5, dans lequel lesdits premier et deuxième éléments de support sont espacés l'un de l'autre sur un bord inférieur (10) dudit séparateur (3) de manière à définir un siège pour positionner ladite bobine dans ledit séparateur.

7. Conteneur (1) selon l'une quelconque des revendications précédentes, dans lequel ledit au moins un élément de support comprend une lèvre (15) qui fait saillie depuis ladite paroi de division (13) et définit un profil d'appui dudit séparateur sur la surface interne de ladite paroi latérale (7) du plateau (2) et sur ladite base (5).

8. Conteneur (1) selon la revendication 7, dans lequel ladite lèvre (15) est reliée à ladite pente (18) et à ladite surface d'appui (14) pour former une nervure faisant saillie depuis ladite paroi de division (13), laquelle nervure s'étend de façon continue le long du périmètre dudit élément de support.

9. Conteneur (1) selon l'une quelconque des revendications précédentes, dans lequel lesdits séparateurs sont positionnés dans ledit plateau de sorte que les éléments de support respectifs se font face deux par deux.

10. Conteneur (1) selon l'une quelconque des revendications précédentes, dans lequel un évidement (19) est réalisé dans une zone médiane d'un bord supérieur (10) de ladite paroi de division (13), lequel évidement facilite la préhension d'une bobine contenue entre lesdits séparateurs (3).
